# FASCICULE DE BREVET EUROPEEN

(11) **EP 0 601 900 B1**
(45) Date de publication et mention de la délivrance du brevet: **01.07.1998**
(21) Numéro de dépôt: 93402669.1
(22) Date de dépôt: 29.10.1993
(51) Int. Cl.: H05K 13/08, G01R 31/28

(54) **Dispositif pour le test manuel d'une carte de circuit imprimé équipée de composants montés en surface**
Manuelle Testanordnung für eine gedruckte Leiterplatte, versehen mit oberflächenmontierten Teilen
Device for the manual testing of a printed circuit board equipped with surface mount components

(30) Priorité: 06.11.1992 FR 9213394
(43) Date de publication de la demande: 15.06.1994
(73) Titulaire: NICOMATIC, 74890 Bons-en-Chablais (FR)
(72) Inventeur: Leilde, Jean-Yves, Thomson-CSF, F-92402 Courbevoie Cédex (FR)
(74) Mandataire: Arnaud, Jean Pierre Alfred

(56) Documents cités:
- DE-A- 3 618 123
- US-A- 4 874 907

## Description

L'invention concerne un dispositif pour le test manuel d'une carte de circuit imprimé équipée de composants montés en surface connus sous l'abréviation CMS.

Ce type de cartes présente des dimensions de plus en plus réduites et de plus en plus denses en composants. L'utilisateur de telles cartes doit avoir accès aux points de tests disposés sur la surface de la carte côté composants pour le réglage, le dépannage, les essais etc... Des moyens de test généralement utilisés pour ce type de circuit sont par exemple, des sondes d'appareil de mesure telles que des sondes d'oscilloscope.

Ces sondes prélèvent l'information au contact d'un point de test ou directement sur les bornes des composants. Ces points de test se présentent par exemple sous la forme d'une plage métallisée en cuivre non vernie déposée sur la surface de la carte du circuit imprimé tel que décrit dans le brevet US-A-4-874 907.

De tels points de test monopolisent l'une des mains de l'utilisateur pour tenir la sonde en contact sur la plage métallisée ou sur les bornes des composants.

L'inconvénient principal de ce type de test est qu'il ne permet pas d'accrocher fixement la sonde de test sur le point de test ou sur le composant monté en surface.

Le but de l'invention est de pallier les inconvénients précités.

A cet effet, l'invention a pour objet un dispositif pour le test manuel d'une carte de circuit imprimé équipée de composants montés en surface, caractérisé en ce qu'il est réalisé dans un matériau rigide et conducteur électrique et comprend un matériau soudable par refusion, la forme du dispositif étant déterminée pour permettre de fixer la base du dispositif sur au moins une plage métallisée à la surface de la carte suivant la technique utilisée pour souder par refusion un composant monté en surface sur la surface de la carte, et d'accrocher une sonde de test standard dans plusieurs directions autour du dispositif, et les dimensions du dispositif étant compatibles de celles d'un composant monté en surface.

Des cartes de circuit imprimé selon l'invention sont définies dans les revendications indépendantes 3 et 4.

L'invention a pour principaux avantages de permettre d'accrocher une sonde de test standard dans plusieurs directions autour du dispositif, d'avoir des dimensions analogues aux CMS et permet de déposer le dispositif sur les cartes de circuit imprimé de la même façon que les CMS avec une mise en place rapide et un encombrement faible.

D'autres avantages et caractéristiques de l'invention apparaîtront plus clairement ci-après à l'aide de la description faite en regard des dessins annexés qui représentent :
- les figures 1a et 1b, deux vues respectives à un mode de réalisation d'un dispositif selon l'invention ;
- la figure 2, une vue en perspective du dispositif positionné sur une carte de circuit imprimé.

Sur ces figures l'échelle n'est pas respectée et les éléments homologues sont désignés par le même repère.

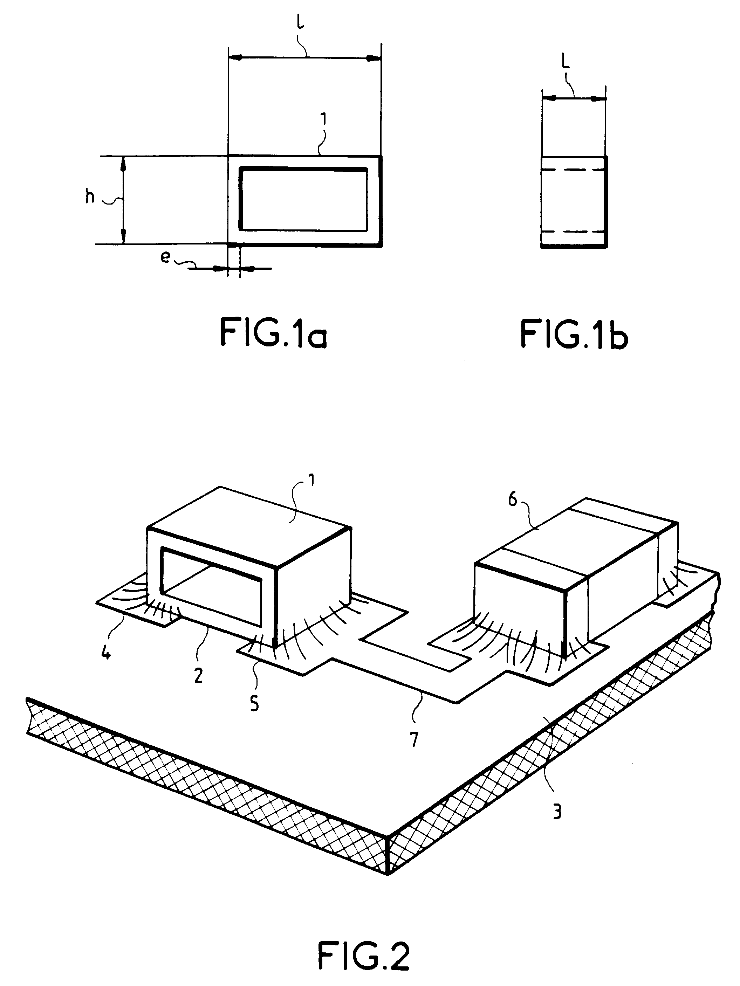

Les figures 1a et 1b illustrent respectivement une vue de face et une vue de côté d'un mode de réalisation d'un dispositif selon l'invention.

Le dispositif comporte un tronçon de tube 1, de section rectangulaire, évidé suivant sa longueur L et réalisé par exemple dans un matériau conducteur par exemple à base de cuivre étamé pour permettre de le souder par refusion sur des plages d'accueil métallisées déposées sur la surface de la carte comme les CMS. L'encombrement du dispositif selon l'invention est similaire aux CMS, par exemple identique à une résistance en CMS. Ses dimensions e, h, I, L et sa forme particulière sont adaptées pour permettre d'accrocher une sonde de test standard dans plusieurs directions autour du tube 1 suivant sa longueur L.

Des valeurs des principales dimensions fonctionnelles de ce mode de réalisation sont données ci-après à titre d'exemple: le dispositif est réalisé à partir d'un tronçon de tube de cuivre 1 de section rectangulaire dont la hauteur h = 1,4 mm, la largeur I = 3,2 mm et la longueur du tronçon L = 1,5 mm. L'épaisseur du tronçon est de e = 0,3 mm.

La figure 2 illustre une vue en perspective d'un dispositif selon le mode de réalisation précédent.

Le tronçon de tube 1 de section rectangulaire est déposé par une de ses deux faces 1 et 2, de largeur I et de longueur L, sur une carte de circuit imprimé 3 par l'intermédiaire de plages d'accueil métallisées 4 et 5 disposées respectivement à chaque extrémité de la face 2 du tube 1. Une résistance 6 en CMS est disposée de la même façon sur la carte 3 et est reliée au dispositif selon l'invention par une piste métallisée 7. Cette figure montre que l'encombrement du dispositif selon l'invention est similaire à celui de la résistance en 6 CMS et que la méthode de dépôt est également la même que pour un CMS.

Bien sûr, l'invention n'est pas limitée au mode de réalisation décrit ci-dessus. D'autres formes et dimensions du dispositif, rentrent également dans le cadre de la présente invention, telle qu'elle est caractérisée dans les revendications, et notamment, un tronçon de tube cylindrique.

De même, d'autres matériaux rentrent également dans le cadre de l'invention, telle qu'elle est caractérisée dans les revendications.

## Revendications

1. Dispositif pour le test manuel d'une carte de circuit imprimé équipée de composants montés en surface, caractérisé en ce qu'il est réalisé dans un matériau rigide et conducteur électrique et comprend un matériau soudable par refusion, la forme du dispositif étant déterminée pour permettre de fixer la base du dispositif sur au moins une plage métallisée (4; 5) à la surface de la carte (3) suivant la technique utilisée pour souder par refusion un composant monté en surface (6) sur la surface de la carte (3), et d'accrocher une sonde de test standard dans plusieurs directions autour du dispositif, et les dimensions (h, I, L) du dispositif étant compatibles de celles d'un composant monté en surface (6).

2. Dispositif selon la revendication 1, caractérisé en ce qu'il comporte un tronçon de tube (1) de section rectangulaire évidé suivant sa longueur (L) et dont la longueur (L), la hauteur (h) et l'épaisseur (e) sont déterminées pour permettre d'accrocher la sonde de test dans plusieurs directions autour de la longueur (L) du tube (1) et de fixer le tube (1) par une (2) de ses faces, servant de base, sur la carte de circuit imprimé (3) comme un composant monté en surface (6).

3. Carte de circuit imprimé comportant sur sa surface des plages métallisées sur lesquelles sont reportées des composants montés en surface, caractérisée en ce quelle comporte au moins une plage métallisée sur laquelle est reporté un dispositif de test selon l'une quelconque des revendications 1 et 2.

4. Carte de circuit imprimé comportant sur sa surface des plages métallisées sur lesquelles sont reportées des composants montés en surface, caractérisée en ce quelle comporte au moins une plage métallisée sur laquelle est reporté un dispositif de test manuel réalisé dans un matériau rigide et conducteur électrique dont la forme permet de fixer la base du dispositif sur au moins une plage métallisée (4 ; 5) à la surface de la carte (3) comme un composant monté en surface (6), et d'accrocher une sonde de test standard dans plusieurs directions autour du dispositif, et dont les dimensions (h, I, L) sont compatibles de celles d'un composant monté en surface (6).

5. Carte de circuit imprimé selon la revendication 4, caractérisée en ce que le dispositif de test reporté comporte un tronçon de tube (1) de section rectangulaire évidé suivant sa longueur (L) et dont la longueur (L), la hauteur (h) et l'épaisseur (e) sont déterminées pour permettre d'accrocher la sonde de test dans plusieurs directions autour de la longueur (L) du tube (1) et de fixer le tube (1) par une (2) de ses faces, servant de base, sur la carte de circuit imprimé (3) comme un composant monté en surface (6).

## Patentansprüche

1. Manuelle Testanordnung für eine mit oberflächenmontierten Bauteilen versehene gedruckte Leiterplatte, gekennzeichnet dadurch, daß die Testanordnung aus einem starren und elektrisch leitenden Material hergestellt ist und ein durch Aufschmelzen lötbares Material umfaßt, wobei die Testanordnung so gestaltet ist, daß ihre Basis auf wenigstens einen metallisierten Bereich (4; 5) der Oberfläche der Leiterplatte (3) in gleicher Weise wie ein durch Aufschmelz-Löten oberflächentmontiertes Bauteil (6) befestigt und eine Standardtestsonde in verschiedene Richtungen um die Anordnung herum ausgerichtet werden kann, und wobei die Testanordnung ferner Abmessungen (h, L, l) aufweist, die denen eines oberflächenmontierten Bauteiles (6) entsprechen.

2. Testanordnung nach Anspruch 1, gekennzeichnet durch einen röhrenförmigen Abschnitt (1) mit rechtwinkligem Querschnitt, der entlang seiner Länge (L) eine Aussparung aufweist und dessen Länge (L), Höhe (h) und Dicke (e) so gewählt sind, daß es möglich ist, die Testsonde in verschiedene Richtungen um die Länge (L) der Röhre (1) herum auszurichten und die Röhre (1) an einer ihrer als Basis dienenden Seiten (2) auf der gedruckten Leiterplatte (3) wie ein oberflächenmontiertes Bauteil (6) zu befestigen.

3. Gedruckte Leiterplatte mit an ihrer Oberfläche befindlichen metallisierten Bereichen, auf denen oberflächenmontierte Bauteile angeordnet sind, dadurch gekennzeichnet, daß die Leiterplatte wenigstens einen metallisierten Bereich umfaßt, auf dem eine Testanordnung nach einem der Ansprüche 1 oder 2 angeordnet ist.

4. Gedruckte Leiterplatte mit an ihrer Oberfläche befindlichen metallisierten Bereichen, auf denen oberflächenmontierte Bauteile angeordnet sind, dadurch gekennzeichnet, daß die Leiterplatte wenigstens einen metallisierten Bereich umfaßt, auf dem eine manuelle Testanordnung aus einem starren, elektrisch leitenden Material angeordnet ist, die so gestaltet ist, daß ihre Basis auf wenigstens einem auf der Oberfläche der Leiterplatte (3) vorgesehenen metallisierten Bereich (4; 5) in gleicher Weise wie ein oberflächenmontiertes Bauteil (6) befestigt und eine Standardtestsonde in verschiedene Richtungen um die Anordnung herum ausgerichtet werden kann, wobei die Testanordnung ferner Abmessungen (h, L, l) aufweist, die denjenigen eines oberflächenmontierten Bauteils (6) entsprechen.

5. Gedruckte Leiterplatte nach Anspruch 4, dadurch gekennzeichnet, daß die eingebaute Testanordnung einen röhrenförmigen Abschnitt (1) mit rechteckigem Querschnitt umfaßt, der entlang seiner Länge (L) eine Aussparung aufweist und dessen Länge (L), Höhe (h) und Dicke (e) so gewählt sind, daß die Testsonde in mehrere Richtungen um die Länge (L) der Röhre (1) herum ausgerichtet und die Röhre (1) an einer ihrer als Basis dienenden Seiten (2) auf der gedruckten Leiterplatte (3) wie ein oberflächenmontiertes Bauteil (6) befestigt werden kann.

## Claims

1. A device for manual testing of a printed circuit card fitted with surface-mount components, the device being characterized in that it is implemented in a rigid electrically-conductive material and includes material (7) suitable for reflow soldering, the shape of the device being designed both to enable the base of the device to be fixed on at least one metallized area (4 ; 5) on the surface of the card (3) depending on the technique used for reflow soldering a surface-mount component (6) on the surface of the card (3), and also to enable a standard test probe to be attached in a plurality of directions around the device, and the dimensions (h, l, L) of the device being compatible with the dimensions of a surface-mount component (6).

2. A device according to claim 1, characterized in that it comprises a length of rectangular section tube (1) that is hollow lengthwise (L) and whose length (L), height (h), and thickness (e) are determined to enable a test probe to engage in a plurality of directions around the length (L) of the tube (1), and to enable the tube (1) to be fixed via a base one (2) of its faces on the printed circuit card (3) like a surface-mount component (6).

3. A printed circuit card including, on its surface, metallized areas on which surface-mount components are secured, the card being characterized in that it includes at least one metallized area on which a test device according to claim 1 or 2 is secured.

4. A printed circuit card including, on its surface, metallized areas on which surface-mount components are secured, the card being characterized in that it includes at least one metallized area on which there is secured a device for manual testing, which device is made of a rigid and electrically-conductive material whose shape both enables the base of the device to be fixed on at least one metallized area (4 ; 5) on the surface of the card (3) like a surface-mount component (6), and also enables a standard test probe to be attached in a plurality of directions around the device, and whose dimensions (h, l, L) are compatible with those of a surface-mount component (6).

5. A printed circuit card according to claim 4, characterized in that the secured device for manual testing includes a length of rectangular section tube (1) that is hollow lengthwise (L) and whose length (L), height (h), and thickness (e) are determined to enable a test probe to be secured in a plurality of directions around the length (L) of the tube (1), and to enable the tube (1) to be fixed via a base one (2) of its faces on the printed circuit card (3) like a surface-mount component (6).
